# EUROPÄISCHE PATENTANMELDUNG

(11) **EP 1 995 345 A1**
(43) Veröffentlichungstag der Anmeldung: **26.11.2008**
(21) Anmeldenummer: 07109008.8
(22) Anmeldetag: 25.05.2007
(51) Int. Cl.: C23C 4/18, C23C 10/48, C23C 10/56, C23C 26/00, C23C 16/56

(54) **Verfahren zur Herstellung eines hochtemperaturbeständigen Werkstoffs**

(71) Anmelder: InnCoa GmbH, 51766 Engelskirchen (DE)
(72) Erfinder: Strobl, Christoph, 85049, Ingolstadt (DE); Heller, Jörg, 51766, Engelskirchen (DE); Oberhauser, Simon, 85296, Rohrbach (DE)
(74) Vertreter: von Kreisler Selting Werner

(57) **Zusammenfassung**

Die Erfindung betrifft ein Verfahren zur Herstellung eines hochtemperaturbeständigen Werkstoffs aus einem Fe- oder FeCr- oder FeNi- oder FeNiCr-Substrat sowie den damit hergestellten Werkstoff und seine Verwendung. Der Werkstoff weist eine harte, zähe, oxidationsbeständige und gegen aggressive Medien resistente Oberfläche auf. Die erfindungsgemäß erhaltenen Werkstoffe können als Werkstücke und Bauteile im allgemeinen Maschinenbau, der Bau- und Fahrzeugbauindustrie, der Luftfahrt, chemischen und petrochemischen Industrie sowie der allgemeinen Industrie Anwendung finden.

## Beschreibung

Die Erfindung betrifft ein Verfahren zur Herstellung eines hochtemperaturbeständigen Werkstoffs aus einem Fe- oder FeCr- oder FeNi- oder FeNiCr-Substrat sowie den damit hergestellten Werkstoff und seine Verwendung. Der Werkstoff weist eine harte, zähe, oxidationsbeständige und gegen aggressive Medien resistente Oberfläche auf. Die erfindungsgemäß erhaltenen Werkstoffe können als Werkstücke und Bauteile im allgemeinen Maschinenbau, der Bau- und Fahrzeugbauindustrie, der Luftfahrt, chemischen und petrochemischen Industrie sowie der allgemeinen Industrie Anwendung finden.

Es ist bekannt, dass durch Cr-Anreicherung der Oberfläche von Ni-Basis- oder Eisenwerkstoffen vor allem die Verschleißbeständigkeit durch die Bildung von sehr harten Chromcarbidschichten auf der Werkstückoberfläche stark erhöht werden kann, indem eine sehr harte Chromcarbidschicht an der Oberfläche ausgebildet wird, die starken Verschleiß während des Betriebs verringert.

Weiterhin ist aus der Luftfahrt bekannt, dass durch Al-Anreicherung der Oberfläche von Ni-Basiswerkstoffen die Oxidationsbeständigkeit der Turbinenschaufeln über den Betrieb bei Temperaturen um 1000°C in der Flugzeugturbine gewährleistet werden kann, indem eine stabile Aluminiumoxidschicht an der Oberfläche ausgebildet wird, die eine starke Oxidation während des Betriebs verhindert.

Die EP-A-0906967 offenbart die Verwendung einer Legierung aus Aluminium und Titan als temperaturbeständiger und korrosionsfester Beschichtungswerkstoff für warmfesten Stahl. Aluminium und Titan bilden durch Reaktion mit der Prozessumgebung extrem stabile Oxide aus, welche eine oxidische Schutzschicht ausbilden.

Die DE-A-4215664 offenbart ein Verfahren zum Aufbringen von metallischen Zwischenschichten vor einer Aluminium-Diffusionsbeschichtung. Die Zwischenschichten werden zur Verminderung der Schichteigenspannungen aufgebracht. Als metallische Zwischenschicht werden Platinmetalle oder ihre Legierungen, Hafnium oder Seltenerdmetalle aufgestäubt.

Die Herstellung von FeCrAl-Legierungen für den Hochtemperaturbereich ist seit längerer Zeit bekannt. Eine großtechnische Verwendung ist jedoch bis heute nicht möglich, da es diese Stähle nur bis max. 6 % Al-Gehalt gibt und diese dazu wegen komplizierter Führung der Schmelze und Umformung schwer verfügbar, fast ausschließlich nur als Draht, und sehr teuer sind.

Zudem bedingen in jüngerer Zeit Anforderungen an moderne Konstruktionen wie Leichtbau, das heißt beispielsweise die Notwendigkeit einer höheren Leistung bei geringerem spezifischem Verbrauch und daraus resultierend einer höheren Wärmebelastung, sowie erhöhte Anforderungen an Schallabsorber verstärkt den Einsatz von neuen Technologien.

Die Herstellung metallischer, oxidischer oder keramischer Hohlkörper, die im Leichtbau und/oder als Schallabsorber eingesetzt werden können, ist seit längerer Zeit bekannt.

Die EP-A-1013890 beschreibt die Verwendung von aufgeschäumten, metallischen, korrosionsbeständigen Hochtemperaturlegierungen als Anstreifdichtung für Turbomaschinen.

Die DE-C-10018501 beschreibt die Herstellung metallischer hohler Formkörper, bei dem Metallverbindungen, die bei einer Temperatur unter 1200°C reduzierbar sind, gelöst oder suspendiert als Hüllschicht auf Trägerelemente aufgebracht werden. Die so hergestellten Grünlinge werden nachfolgend wärmebehandelt, wobei die Trägerelemente pyrolysiert, die Hüllschichten thermisch zersetzt und die Zersetzungsprodukte gesintert werden.

In dem in der DE-A-19929760 beschriebenen Verfahren zur Herstellung metallischer, oxidischer oder keramischer Hohlkugeln werden ein Bindemittel und ein trockener, pulver- oder granulatförmiger Ausgangsstoff auf kugelförmige Trägerelemente aufgetragen. Die so hergestellten Grünlinge werden nachfolgend pyrolisiert und gesintert.

Von besonderer Bedeutung für einen industriellen Einsatz derartiger poröser, aber auch kompakter Strukturen sind das Erreichen entsprechender mechanischer Eigenschaften basierend auf angepasster Zusammensetzung, Legierung der vorhandenen Elemente in der Struktur, dem Einsatzfall entsprechender Heißgasbeständigkeit, Hochtemperaturverschleißverhalten und Hochtemperaturkorrosionsverhalten sowie, falls zur Herstellung von porösen Strukturen erforderlich, zuordenbarer Außenmaße des Ausgangspulvers.

Dies kann nach dem Stand der Technik durch Einsatz entsprechender Legierungen, Mehrschichtsysteme und den beschriebenen Herstellverfahren realisiert werden. Die Variabilität der einsetzbaren Legierungen und, falls erforderlich, der Körnchengröße im Stand der Technik ist dabei sehr stark durch technische Machbarkeit und vor allem durch mögliche industrielle Fertigungsverfahren eingeschränkt, wie beispielsweise in der EP 1 272 300 beschrieben. Dies bedeutet unter anderem, wie oben am Beispiel Al-Legierungsgehalt beschrieben, bei FeCrAl-Legierungen ein Maximum des Aluminiumgehalts von ca. 6 % beim neuentwickelten Werkstoff PM2000.

Die im Stand der Technik eingesetzten Metallverbindungen und Legierungen sind zudem wie die ursprünglichen Ausgangswerkstoffe in ihren Eigenschaften bezüglich mechanischem Verhalten (Kombination von Zähigkeit und Festigkeit) oder ihrer Einsetzbarkeit bei hohen Temperaturen im praktischen Einsatz stark eingeschränkt.

Ein der Erfindung zugrunde liegendes Problem war daher die Zurverfügungstellung eines Verfahrens, welches erlaubt, auf der Basis kostengünstiger Ausgangsmaterialien kompakte Systeme und/oder auf der Basis kostengünstiger Ausgangsstrukturen bzw. einfacher Pulver poröse Systeme zu schaffen, die verschiedensten teils extremen Einsatzbedingungen gerecht werden.

Dabei soll im Falle von porösen Systemen die Möglichkeit der Verwendung aller möglichen Pulverteilchengrößen gewährleistet werden. Eine nachfolgende Abdichtung bzw. Schließung der Poren soll realisiert werden.

Weitere Aufgaben waren die Zurverfügungstellung und Verwendung von Werkstoffen, welche eine harte, zähe, oxidationsbeständige und gegen aggressive Medien resistente Oberfläche aufweisen, sowie von Werkstücken und Bauteilen, die diese Werkstoffe umfassen.

Eine Vereinfachung und damit wirtschaftliche Verbesserung der Herstellungsverfahren entsprechender FeCrAl-Legierungen als kompakte Substrate oder als Hohlkörper bzw. poröse Strukturen ist ebenfalls Aufgabe der Erfindung. Außerdem soll die Erfindung die bisherige Einschränkung bei der Herstellung von hochtemperaturbeständigen Hohlkörpern bzw. porösen Strukturen aus industriell kaum verfügbaren FeCrAl-Pulvern lösen und die Möglichkeit der frei einstellbaren Legierungsgehalte von Chrom und Aluminium in FeCrAl-Legierungen bieten.

Die der Erfindung zugrunde liegende Aufgabe wurde gelöst durch ein Verfahren zur Herstellung eines hochtemperaturbeständigen Werkstoffs aus einem Fe- oder FeCr- oder FeNi- oder FeNiCr-Substrat, umfassend die Schritte einer Beschichtung des Substrats mit Al oder mit Cr und Al und einer Diffusionswärmebehandlung des beschichteten Substrats.

Die Aufgabe wird weiterhin durch nach dem erfindungsgemäßen Verfahren herstellbare Werkstoffe sowie durch ihre Verwendung gelöst.

Auf die in den Unteransprüchen wiedergegebenen bevorzugten Ausgestaltungen der Erfindung wird ausdrücklich Bezug genommen.

Figur 1 zeigt die Vergrößerung einer fotografischen Aufnahme eines Chromstahls (Werkstoffnummer 1.4016), der als Ausgangsmaterial für das erfindungsgemäße Verfahren dienen kann, nach einer 48stündigen Lagerung bei 1000°C.

Figur 2 zeigt die Vergrößerung einer fotografischen Aufnahme einer gemäß einer Ausführung der Erfindung aus Chromstahl hergestellten FeCrAl-Legierung nach einer 48stündigen Lagerung bei 1000°C.

Figur 3 zeigt die Masseänderung eines unbeschichteten Substrats und eines erfindungsgemäß hergestellten hochtemperaturbeständigen Werkstoffs in einem Auslagerungsversuch in Abhängigkeit von der Zeit.

Gemäß dem erfindungsgemäßen Verfahren wird ein hochtemperaturbeständiger Werkstoff aus einem Fe- oder FeCr- oder FeNi- oder FeNiCr-Substrat hergestellt, umfassend die Schritte
a) Beschichtung des Substrats mit Al oder mit Cr und Al und
b) Diffusionswärmebehandlung des in Schritt a) beschichteten Substrats.

Das heißt, unter Verwendung des erfindungsgemäßen Verfahren wird ein hochtemperaturbeständiger FeNiCrAl-Werkstoff aus einem FeNi-Substrat erhalten, wenn im Schritt a) mit Cr und Al beschichtet wird, und alternativ aus einem FeNiCr-Substrat erhalten, wenn im Schritt a) mit Al oder mit Cr und Al beschichtet wird. Weiterhin wird ein hochtemperaturbeständiger FeCrAl-Werkstoff aus einem Fe-Substrat erhalten, wenn im Schritt a) mit Cr und Al beschichtet wird, und alternativ aus einem FeCr-Substrat erhalten, wenn im Schritt a) mit Al oder mit Cr und Al beschichtet wird. Im Folgenden bedeutet der Begriff Fe(Ni)CrAl-Werkstoff FeNiCrAl-Werkstoff oder FeCrAl-Werkstoff oder ein Gemisch aus einem FeNiCrAl-Werkstoff und einem FeCrAl-Werkstoff.

Vorzugsweise enthalten Substrat und Werkstoff kein Nickel oder weisen einen Nickelgehalt von unter 12 Gew.-%, bevorzugt von unter 7 Gew.-% und bevorzugter von unter 3 Gew.-% auf.

Die Diffusionswärmebehandlung gemäß der Erfindung ist eine thermische Behandlung, bei der es zur Interdiffusion, also der Diffusion der Elemente, zwischen der Beschichtung, die erfindungsgemäß unmittelbar, d. h. ohne Zwischenschicht auf dem Substrat aufgetragen ist, und dem Substrat kommt, wodurch eine oder mehrere Phase(n) oder Legierung(en) oder ein oder mehrere Mischkristall(e) ausgebildet wird/werden, die sowohl Elemente des Substrats als auch Elemente der Beschichtung aufweist. Der erfindungsgemäß hergestellte hochtemperaturbeständige Werkstoff kann einen Gradientenschichtaufbau aufweisen, bei dem sich die Zusammensetzung einer senkrecht zur Oberfläche stehenden Achse kontinuierlich verändert. Alternativ kann der erfindungsgemäß hergestellte hochtemperaturbeständige Werkstoff eine homogene Elementverteilung aufweisen. Die Anreicherung mit den Elementen der Beschichtung kann im Wesentlichen nur den Randbereich des erfindungsgemäß hergestellten Werkstoffs, wobei der innere Bereich auch zu geringen Anteilen auflegiert sein kann, oder alternativ den gesamten erfindungsgemäß hergestellten Werkstoff umfassen.

Die erfindungsgemäßen hochtemperaturbeständigen Werkstoffe sind Werkstoffe, die bei Temperaturen im Bereich von 550°C bis 1000°C, bevorzugt bis 1150°C, am meisten bevorzugt bis 1300°C stabil sind.

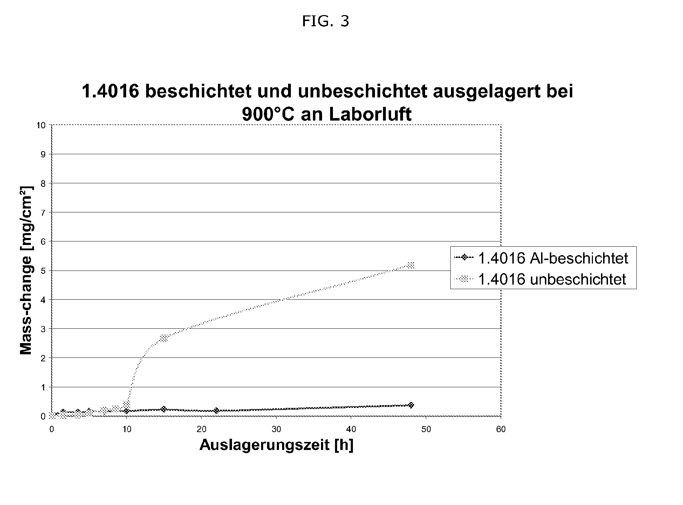

Zur Bestimmung der Oxidationsbeständigkeit, beispielsweise der Stabilität hinsichtlich einer Oxidation bei 900°C, werden Auslagerungsversuche mit gleichzeitiger Bestimmung der Massenänderung, die ein Maß für die Bildung von Oxiden ist, durchgeführt. Hierbei werden die erfindungsgemäß hergestellten Werkstoffe und ein unbeschichtetes Substrat als Kontrollsubstrat bis zu 1000 h bei 900°C im Ofen gelagert. In zeitlichen Abständen wird die Massenänderung der erfindungsgemäß hergestellten Werkstoffe bestimmt und mit der des Kontrollsubstrats verglichen (siehe Figur 3).

Vorzugsweise weist die auf das Substrat aufgetragene Schicht aus Aluminium oder Aluminium und Chrom eine durchschnittliche Dicke von 0,1 µm bis 500 µm, mehr bevorzugt von 1 µm bis 100 µm, besonders bevorzugt von 2 µm bis 30 µm auf.

In einer bevorzugten Ausführungsform erfolgt die Beschichtung a) über ein CVD-, Pack- oder Out-of-Pack-Verfahren simultan mit der Diffusionswärmebehandlung b).

Beim Pack-Verfahren wird das Substrat in ein Pulvergemisch aus dem Aktivator, bestehend aus Halogenverbindungen (z. B. NH₄Cl, NaCl, AlCl₃, NH₄Br, NaBr, AlBr₃, NH₄I, NaI, AlI₃), aus dem Donator (Al-Pulver oder Mischungen aus Al-Pulver und Cr-Pulver) und aus dem inerten Füllmaterial (z. B. Al₂O₃, SiO₂) gepackt und unter Schutzgasatmosphäre einige Stunden bei hohen Temperaturen behandelt.

Beim CVD-Beschichten wird die metallische Beschichtung auf dem erhitzten Substrat abgeschieden. Gasförmige Reaktanten werden hierfür im oberflächennahen Bereich des Substrats zersetzt oder verbunden, wobei Aluminium oder Aluminium und Chrom als Element, Legierung oder Verbindung auf dem Substrat abgeschieden wird. Geeignete Ausgangsstoffe, d. h. Aktivatoren und Donatoren, sind dieselben, die für das Pack-Verfahren verwendet werden können, wobei Al-haltiges und Cr-haltiges Granulat und/oder Pulver, vorzugsweise Legierungen dieser Metalle, vom Substrat räumlich getrennt sind. Das CVD-Beschichten schließt die Abscheidung mittels gerichtetem Gasfluss ohne direkten Pulverkontakt des Substrats (Out-of-pack) ein.

Die beim Out-of-Pack-Verfahren verwendeten gasförmigen Reaktanten werden mit denselben Hauptreaktionen und Parametern erzeugt wie beim Pack-Beschichten, mit der Ausnahme, dass das zu beschichtende Substrat keinen Kontakt mit dem Pulvergemisch hat.

In einer anderen bevorzugten Ausführungsform erfolgt die Beschichtung a) über Beschichtungsverfahren, ausgewählt aus der Gruppe, bestehend aus galvanischen Beschichtungsverfahren, Beschichtungen mittels ionischer Flüssigkeiten, Beschichtungen mittels MOCVD-Verfahren und Spritzverfahren und ist großteils getrennt von der Diffusionswärmebehandlung b).

Ionische Flüssigkeiten sind nichtflüchtige Salze mit einem Schmelzpunkt unterhalb von 100°C. Im Rahmen der Erfindung geeignete ionische Flüssigkeiten sind bevorzugt ausgewählt aus der Gruppe, bestehend aus Trihexyl(tetradecyl)-phosphoniumchlorid ((C6)3(C14)PCI), 1-Octadecyl-3-methylimidazoliumchlorid ((C18)MIMCI), Benzyltriethylammonium (C13H22NCl), 1-Heptyl-3-methylimidazoliumchlorid ((C7)MIMCI), 1-Hexyl-3-methylimidazoliumchlorid ((C6)MIMCI), 1-Butyl-3-methylimidazoliumchlorid (BMIMCI) und 1-Ethyl-3-methylimidazoliumchlorid (EMIMCI).

Großteils getrennt heißt, dass die Beschichtung in einem Temperaturbereich stattfindet, bei dem Diffusionsprozesse in einer noch nicht messbaren Geschwindigkeit stattfinden, so dass die Interdiffusion, also die Diffusion der Elemente zwischen der Beschichtung und dem Substrat, unterbleibt und der Diffusionsschritt als eigenständige Wärmebehandlung in einem separaten Verfahrensschritt nachgestellt wird. Bevorzugt findet die Diffusionswärmebehandlung b) getrennt von der Beschichtung a) statt.

Die Trennung der Schritte a) und b) ermöglicht es, den erfindungsgemäß hergestellten Werkstoff ganz den Erfordernissen des Diffusionsprozesses sowie den etwaigen Erfordernissen einer Wärmebehandlung des Substrates oder einer weiteren Oberflächen- und/oder Substratmodifikation durch Prozessgase oder anderen Medien anzupassen, ohne auf die prozesstechnischen Einengungen Rücksicht nehmen zu müssen.

Das MOCVD-Verfahren ist ein CVD-Verfahren auf der Basis leicht flüchtiger metallorganischer Verbindungen. Unter leicht flüchtigen Metallverbindungen sind solche zu verstehen, die bei Normaldruck (101,325 kPa) einen Sublimations- oder Siedepunkt von 300°C oder weniger aufweisen. Geeignete Metallverbindungen sind ausgewählt sind aus der Gruppe, bestehend aus Metall-Alkylen, bevorzugt C₁-C₁₀-Alkyl, Metall-Carbonylen, Metall-π-Komplexen und Metallverbindungen, die mehrere dieser Strukturen gemischt aufweisen, wobei die Metalle Chrom und/oder Aluminium sind. Besonders bevorzugt sind Triethylaluminium (TEAL), Triisobutylaluminium (TIBAL), Diisobutylaluminiumhydrid (DIBAL) und Chromhexacarbonyl.

In der Erfindung geeignete Spritzverfahren sind das thermische Spritzen und das Kaltgasspritzen.

Beim Kaltgasspritzen wird das Beschichtungsmaterial in Pulverform mit sehr hoher Geschwindigkeit auf das Substrat aufgebracht. Dazu wird ein auf nur wenige hundert °C aufgeheiztes Prozessgas auf Überschallgeschwindigkeit beschleunigt und anschließend werden die Pulverpartikel in den Gasstrahl injiziert. Die injizierten Spritzpartikel werden dabei auf eine so hohe Geschwindigkeit beschleunigt, dass sie im Gegensatz zu anderen thermischen Spritzverfahren auch ohne vorangehendes An- oder Aufschmelzen beim Aufprall auf das Substrat eine dichte und fest haftende Schicht bilden. Die kinetische Energie zum Zeitpunkt des Aufpralls reicht für ein vollständiges Aufschmelzen der Partikel nicht aus.

Das thermische Spritzen schließt Flammspritzen (vor allem das Drahtflammspritzen, Pulverflammspritzen), Lichtbogenspritzen, Detonationsspritzen (Flammschockspritzen) und Plasmaspritzen ein.

Beim Drahtflammspritzen wird der drahtförmige Spritzzusatz mit einer Brenngas-Sauerstoff-Flamme geschmolzen und durch das Verbrennungsgas allein auf die Bauteiloberfläche gespritzt. Beim Pulverflammspritzen wird mit pulverförmigen Spritzzusätzen gearbeitet.

Beim Lichtbogenspritzen wird ein Draht- oder Fülldraht-Spritzzusatz in einem elektrischen Lichtbogen geschmolzen und durch ein Zerstäubergas (Luft) auf die Bauteiloberfläche geschleudert. Der elektrische Lichtbogen wird zwischen den beiden Drahtenden durch Anlegen einer Spannung und Kontaktzündung erzeugt.

Das Flammschockspritzen benutzt die Energie, die durch gesteuerte Detonationen aus Sauerstoff- und Gasmischungen freigesetzt wird, um Pulverpartikel zu erhitzen und zu beschleunigen.

Beim Plasmaspritzen wird das pulverförmige Beschichtungsmaterial mit Hilfe eines Trägergases in einen energiereichen Plasmastrahl eingebracht , das durch die hohe Plasmatemperatur aufgeschmolzen wird. Der Plasmagasstrom reißt die Pulverteilchen mit und schleudert sie auf das zu beschichtende Substrat.

Die oben genannten Verfahren sind dem Fachmann hinlänglich bekannt und es kann insoweit auf den Stand der Technik verwiesen werden.

Werden Substrate mit porösen Strukturen beschichtet, werden galvanischen Beschichtungsverfahren sowie thermische Spritzverfahren bevorzugt nicht verwendet, um die porösen Struktur des Substrats zu erhalten.

In einer besonderen Ausgestaltung des erfindungsgemäßen Verfahrens erfolgt die Diffusionswärmebehandlung im offenen Ofen, im Vakuum oder bei Unterdruck, vorzugsweise einem Druck von 10⁻⁸ bar oder größer, besonders bevorzugt von 1 mbar oder größer, (z. B. im Induktionsofen) und/oder in Gegenwart von Prozessgasen.

Bei der Durchführung des erfindungsgemäßen Verfahrens im Vakuum können organische Reste oder Sauerstoff entfernt werden.

Alternativ besteht durch die separate nachgestellte Diffusionswärmebehandlung die Möglichkeit einer zusätzlichen Oberflächen- bzw. Substratmodifikation durch gezielten Einsatz von Prozessgasen oder anderen Medien. Dies bietet zum einen die Möglichkeit der gezielten Bildung des erfindungsgemäß hergestellten Werkstoffs und zum anderen, dass durch eine erhöhte Spülrate eine beschleunigte Werkstoff-Abkühlung herbeigeführt werden kann, welche eine Härtung bzw. eine Einstellung des gewünschten Gefügezustandes des Werkstoffs ermöglicht. Dies steht im Gegensatz zum Pack- oder CVD-Prozess, bei welchem dies während der Wärmebehandlung nicht möglich ist.

Im erfindungsgemäßen Verfahren sind die folgenden Prozessgase besonders geeignet: Argon, Wasserstoff, Stickstoff, stickstoffhaltige Gase, kohlenstoffhaltige Gase, borhaltige Gase und deren Gemischen.

Das kohlenstoffhaltige Gas ist bevorzugt Methan, Ethan, Propan, Butan, Acetylen, Kohlenmonoxid oder ein Gemisch daraus.

Das stickstoffhaltige Gas ist bevorzugt Ammoniak, ein Monoalkylamin, wie Methylamin, ein Dialkylamin, wie Dimethylamin, ein Trialkylamin, wie Triethylamin, Borazin oder ein Gemisch daraus. Besonders bevorzugt enthält das stickstoffhaltige Gas keine sauerstoffhaltige Verbindung.

Das borhaltige Gas ist bevorzugt ausgewählt aus der Gruppe der Borane, wie Diboran, Carborane, und/oder Boralkyle, wie Triethylboran, oder Borazin.

Besonders bevorzugt enthält das borhaltige Gas keine sauerstoffhaltige Verbindung.

Bevorzugt sind Gemische aus Methan mit Kohlenmonoxid und Acetylen.

Je nach dem, ob die Prozessgase kohlenstoffhaltige Gase, stickstoffhaltige Gase, borhaltige Gase oder deren Gemische enthalten, enthält der durch das erfindungsgemäße Verfahren erhaltene Werkstoff Carbide und/oder Nitride und/oder Carbonitride und/oder Boride. Bei kohlenstoffhaltigen Substraten kann ferner der enthaltene Kohlenstoff zur Bildung von Metall-Carbiden führen.

Als weiteren Schritt des erfindungsgemäßen Verfahrens kann eine beschleunigte Abkühlung des Substrats in Gegenwart von Prozessgasen und/oder anderen Medien durchgeführt werden. Bevorzugt werden die oben genannten Prozessgase und/oder anderen Medien verwendet. Eine gesteuerte, vorzugsweise beschleunigte Abkühlung des beschichteten Substrats kann beispielsweise in Gegenwart von flüssigen Medien wie Öl, Wasser, Salzbäder, flüssigen Gasen oder geschmolzenem Blei durchgeführt werden.

Durch diesen in der Regel den oben beschriebenen Verfahrensschritten a) und b) nachfolgenden Schritt der beschleunigten Abkühlung/des Abschreckens lassen sich die mechanischen Eigenschaften des erfindungsgemäß hergestellten Werkstoffs gezielt einstellen.

Die gemäß dem Verfahren der Erfindung erfolgende thermische Behandlung, d. h. die Diffusionswärmebehandlung, kann typischerweise bei einer Temperatur von 250°C bis 1600°C, vorzugsweise bei einer Temperatur von 800°C bis 1300°C, besonders bevorzugt bei einer Temperatur von 900°C bis 1200°C durchgeführt werden.

Bevorzugt erfolgt die Diffusionswärmebehandlung für einen Zeitraum von 0,1 h bis 250 h, vorzugsweise von 2 h bis 16 h, besonders bevorzugt von 3 h bis 12 h.

In einer besonderen Ausgestaltung ist das erfindungsgemäße Substrat ein kompaktes Substrat, vorzugsweise ausgewählt aus Bandmaterial oder kompakten Bauteilen. Bevorzugt weist ein kompaktes Substrat ein Gefüge mit einem Hohlraumanteil unter 15 %, bevorzugt unter 5 % auf.

Bevorzugt handelt es sich bei dem kompakten Substrat um ein dünnes Substrat, wobei dessen geringste Wandstärke vorzugsweise maximal 5 mm oder weniger, bevorzugter 2 mm oder weniger, besonders bevorzugt 0,5 mm oder weniger beträgt.

Die Wandstärke ist der von einem Punkt der Oberfläche aus senkrecht zur Oberfläche gemessene Abstand zur gegenüber liegenden Oberfläche.

Das erfindungsgemäße Verfahren ist besonders vorteilhaft für dünne Substrate anwendbar, da hier auf einfache und schnelle Art und Weise vollständig durchlegierte Werkstoffe erhalten werden können, die im Stand der Technik nicht bekannt sind.

Bevorzugt besteht das kompakte Substrat aus un-, niedrig- oder hochlegiertem Cr-Stahl, NiCr-Stahl, Cr-Gusseisen, Cr-Stahlguss, NiCr-Stahlguss und enthält gegebenenfalls zusätzlich ein Element oder mehrere Elemente, ausgewählt aus W, Mo, Ni, Ta, Nb, Zr, V, Hf, Ru, Rh, Os, Ir, Pd, Pt, Re, Y.

In einer bevorzugten Ausgestaltung erfolgt die Beschichtung des kompakten Substrats mittels eines diskontinuierlichen Verfahrens oder mittels eines kontinuierlichen Verfahrens (Durchlaufverfahren). Besonders bevorzugt erfolgt die Beschichtung und nachfolgende Diffusionswärmebehandlung des Substrats als Stückgut über Trommel- oder Gestellprozesse.

In einer alternativen Ausgestaltung ist das kompakte Substrat ein Bandmaterial und wird als solches beschichtet und nachfolgend diffusionswärmebehandelt.

In einer besonderen Ausführungsform wird das im Schritt a) erhaltene beschichtete Substrat oder der durch die Schritte a) und b) erhaltene Werkstoff in einem weiteren Schritt durch Tiefzieh- oder anderen Umformprozessen vor und/oder nach der Diffusionswärmebehandlung in die gewünschte Endform gebracht.

In einer weiteren besonderen Ausgestaltung der Erfindung ist das Substrat ein poröser Formkörper. Der erfindungsgemäße poröse Formkörper besteht bevorzugt aus einer metallischen gesinterten Hohlkugelstruktur, aus einer metallischen Schwammstruktur oder aus einer sonstigen metallischen porösen Struktur

Geeignete hochporöse metallische Werksstoffe auf Basis schmelzextrahierter Metallfasern und pulvermetallurgisch hergestellter Hohlkugeln, offenzelliger Metallschäume und Siebdruckstrukturen sind vom Fraunhofer-Institut für Fertigungstechnik und Angewandte Materialforschung, Dresden, erhältlich. Geeignete Hohlkugeln und Hohlkugelstrukturen sind von Glatt Systemtechnik GmbH, Dresden, erhältlich.

In einer alternativen Ausgestaltung der Erfindung besteht das Substrat aus Einzelkörper, die temporär durch Klebstoffe in der Endform fixiert sind.

Bevorzugt werden die Einzelkörper während der Diffusionswärmebehandlung b) zu einem porösen Formkörper gesintert.

Geeignete Klebstoffe zersetzen sich bei den zur Diffusionswärmebehandlung notwendigen Temperaturen und/oder verdampfen bei diesen Temperaturen, wie zum Beispiel Zellulosekleister. Bevorzugt werden flüchtige Klebstoffe verwendet.

Die Einzelkörper sind bevorzugt Hohlkörper wie Kugeln oder andere geometrische Körper. Alternativ ist das Substrat als Metallisierung, zum Beispiel in Form eines Pulvers, auf beliebig geformte Trägerelemente aufgetragen und bildet mit diesem sogenannte Grünlinge. In diesem Fall beschreibt die Metallisierung die erfindungsgemäß verwendeten Einzelkörper. Das Pulver kann durch ein Bindemittel oder Klebstoff wie oben definiert auf den Trägerelementen fixiert sein. Die Trägerelemente, wie Kugeln oder andere geometrische Körper, bestehen vorzugsweise aus einem polymeren Material, das sich bei den zur Diffusionswärmebehandlung notwendigen Temperaturen zersetzt und/oder die bei diesen Temperaturen verdampft, wie zum Beispiel Styroporkugeln. Bevorzugt weisen die Hohlkugeln Durchmesser von 20 mm und kleiner, bevorzugter 10 mm und kleiner, noch bevorzugter 2 mm und kleiner, besonders bevorzugt 1 mm und kleiner auf. Die Wandstärke der Hohlkugeln beträgt bevorzugt 10 bis 100 µm, bevorzugter 20 bis 60 µm und besonders bevorzugt 30 bis 50 µm.

Optional sind die Einzelkörper auf einer Trägerplatte angeordnet.

Die erfindungsgemäß verwendeten Hohlkörper bzw. die porösen Strukturen liegen nach einer eventuell notwendigen Sinterung metallisch als sehr leichte Körper mit relativ hoher Festigkeit vor. Die Dichte der porösen Strukturen beträgt vorzugsweise 30 % und weniger, bevorzugter 10 % und weniger als die Dichte eines kompakten Substrats. Besonders bevorzugt beträgt die Dichte einer porösen Struktur 3 bis 5 % der Dichte eines kompakten Substrats.

Durch das erfindungsgemäße Verfahren ist es möglich, den Aluminium- und/oder Chromgehalt der zu erhaltenen Legierung frei einzustellen. Dies erlaubt beispielsweise die Herstellung von porösen Strukturen, die nicht durch die Sinterung von Legierungspulvern möglich ist, wenn keine Legierungspulvern in der gewünschten Zusammensetzung erhältlich sind. Gleichzeitig werden durch die Wärmebehandlung und den Diffusionseintrag von Aluminium oder Aluminium und Chrom die Poren geschlossen. Sowohl der zu erreichende Gehalt an Aluminium und/oder Chrom und die stärker geschlossene Porosität der Strukturen führt zu einer besseren Oxidationsbeständigkeit der Substrate gemäß der Erfindung.

In einer Ausgestaltung besteht das poröse Substrat aus einem un-, niedrig- oder hochlegierte Eisenbasiswerkstoff oder einem FeCr- oder FeNi- oder FeNiCr-Werkstoff, wobei der Werkstoff zusätzlich die Elemente W, Mo, Ta, Nb, Zr, V, Hf, Ru, Rh, Os, Ir, Pd, Pt, Re, Y enthalten kann.

Bevorzugt wird der Werkstoff in der gewünschten Endform und/oder mit den gewünschten Endabmessungen hergestellt.

In einer bevorzugten Ausführungsform weist der nach dem erfindungsgemäßen Verfahren hergestellte Werkstoff ein kompaktes Gefüge mit einem Hohlraumanteil unter 15 Vol.-%, besonders bevorzugt unter 5 Vol.-% auf.

In einer alternativen Ausführungsform weist der nach dem erfindungsgemäßen Verfahren hergestellte Werkstoff einen Hohlraumanteil von über 55 Vol.-%, bevorzugt von über 65 Vol.-% auf.

Bevorzugt weist der erfindungsgemäß hergestellte Werkstoff eine homogene Elementverteilung auf. In einer weiteren Ausgestaltungsform weist der erfindungsgemäß hergestellte Werkstoff einen Aluminiumgehalt von über 6 Gew.-%, bevorzugter von über 6,5 Gew.-%, noch bevorzugter von über 7 Gew.-%, ebenfalls bevorzugt von über 8 Gew.-% und am meisten bevorzugt von über 10 Gew.-% auf. Der Aluminiumgehalt innerhalb des erfindungsgemäß hergestellten Werkstoffs ist bevorzugt maximal 40 Gew.-%, bevorzugter maximal 30 Gew.-%, noch bevorzugter maximal 22 Gew.-%, ebenfalls bevorzugt maximal 18 Gew.-% und am meisten bevorzugt maximal 15 Gew.-%.

Bevorzugt enthält der erfindungsgemäß hergestellte Werkstoff Carbide und/oder Nitride und/oder Carbonitride und/oder Boride enthalten sind.

Bevorzugt weist der Werkstoff eine Vickershärte in einem Bereich von 120 bis 1150, bevorzugter von 200 bis 850, gemessen nach DIN EN ISO 6507-1 (2004-07), auf.

Erzeugnisse, umfassend den erfindungsgemäßen Werkstoff schließen Halbzeuge, Werkstücke, Form- und Bauteile ein.

Erzeugnisse, umfassend den erfindungsgemäßen Werkstoff, finden Anwendung in der Luftfahrt, im Abgasbereich von Automotivanwendung, in der Petrochemie und allgemeinen Industrie, insbesondere wenn Oxidationsschutz, Zunderschutz, Heißgas-Korrosionsschutz, zum Schutz gegen Metalldusting, zum Schutz vor Sulfidierung, als Korrosionsschutz, als Verschleißschutz, zur Erhöhung des abrasiven Widerstandes, zur Reduzierung der Adhäsion, der Verbesserung der tribologischen Eigenschaften und/oder zum Schutz vor aggressiven Metallschmelzen (Zn, Al, Mg oder deren Gemische) benötigt wird.

Besonders bevorzugt sind Anwendungen in der Luftfahrt, z. B. in Dichtungssystemen, im Abgasbereich von Automotivanwendung, z. B. als Hitzeschutzblech, und als Bauteile in Brennstoffzellen.

Erzeugnisse, umfassend den erfindungsgemäßen Werkstoff, finden ebenfalls Anwendung als Leichtbauformkörper, insbesondere als oxidationsbeständige Anstreifdichtung in der Luftfahrt sowie als Werkstück und Bauteil im allgemeinen Maschinenbau, der Bau- und Fahrzeugbauindustrie, der Luftfahrt, chemischen und petrochemischen Industrie sowie der allgemeinen Industrie, insbesondere wenn Oxidationsschutz, Zunderschutz, Heißgas-Korrosionsschutz, Schutz gegen Metalldusting, Schutz vor Sulfidierung, Korrosionsschutz, Verschleißschutz, eine Erhöhung des abrasiven Widerstandes, Reduzierung der Adhäsion und/oder Verbesserung der tribologischen Eigenschaften benötigt wird.

Konkrete Beispiele für kompakte Substrate sind Drähte, Bleche, Bandmaterial, Maschinenbauteile, Schrauben, Muttern oder Turbinenschaufeln.

Die Erfindung wird durch die nachfolgenden Beispiele näher erläutert, ohne jedoch darauf beschränkt zu sein.

### Beispiele

Die nachfolgend beschriebenen Verfahren wurden in handelsüblichen, auf dem Gebiet der Erfindung gebräuchlichen Vorrichtungen durchgeführt.

### Beispiel 1:

Auf einen Chromstahl (Werkstoffnummer 1.4016) wurde eine Rein-Aluminiumschicht mittels MOCVD-Verfahren aufgebracht und anschließend das beschichtete Werkstück im Temperaturbereich von 800°C - 1100°C über sechs bis acht Stunden diffusionswärmebehandelt. Der erhaltene Werkstoff weist in seinem Aufbau über den gesamten Querschnitt eine homogene Elementverteilung von 77 % Fe, 15 % Cr, 8% Al auf. Mit dieser Zusammensetzung übertrifft dieser FeCrAl-Werkstoff hinsichtlich des Al-Gehaltes, der für die sehr guten Oxidationsbeständigkeiten steht, sogar noch die im Handel schwer verfügbaren PM2000-Legierungen mit nur 6% Al. Insgesamt übertrifft die so hergestellte FeCrAl-Legierung bei weitem die Oxidationseigenschaften des unbeschichteten Chromstahls.

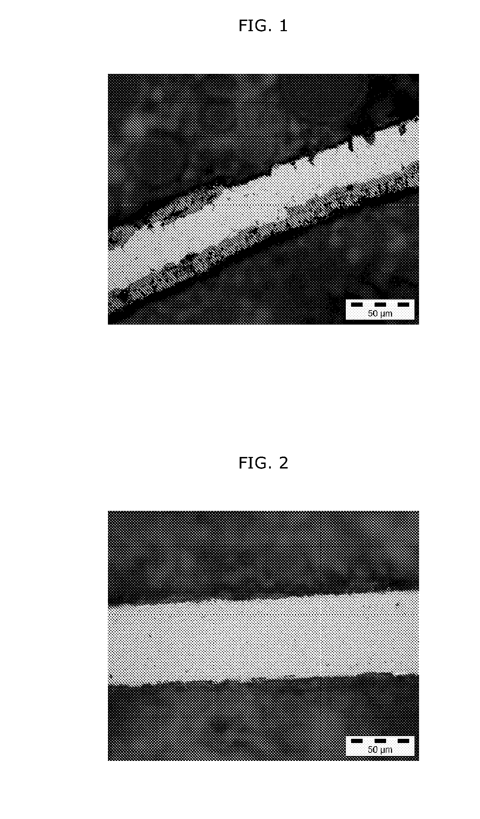

Figur 1 zeigt den als Ausgangsmaterial verwendeten Chromstahl nach einer 48stündigen Lagerung bei 1000°C. Deutlich zu erkennen ist eine stellenweise über 10 µm dicke Oxidationsschicht. Bei der in Figur 2 dargestellten Probe handelt es sich um eine erfindungsgemäß hergestellte FeCrAl-Legierung, die ebenfalls einer 48stündigen Lagerung bei 1000°C unterzogen wurde. Es ist kein Oxidationsangriff auf das Substrat zu erkennen.

### Beispiel 2:

Auf einen Chromstahl (Werkstoffnummer 1.4016) wurde eine Rein-Aluminiumschicht mittels MOCVD-Verfahren aufgebracht, anschließend wurde das beschichtete Werkstück im Temperaturbereich von 800°C - 1100°C über zwei bis vier Stunden diffusionswärmebehandelt. Das Profil der Elementverteilung im erhaltenen Werkstoff weist einen symmetrisch zur Bauteilmitte außen erhöhten Anteil an Al auf, was einen sehr guten Oxidationsschutz für die Randzone bietet. Der innere Bereich dagegen ist nahezu nicht auflegiert, so dass hier auch die bisherigen mechanischen Eigenschaften des Substrats nicht beeinflusst werden.

### Beispiel 3:

Auf einen Chromstahl (Werkstoffnummer 1.4016) wurde eine Rein-Aluminiumschicht mittels MOCVD-Verfahren aufgebracht, anschließend wurde das beschichtete Werkstück im Temperaturbereich von 800°C - 1100°C über zwei bis vier Stunden diffusionswärmebehandelt. Das Profil der Elementverteilung im erhaltenen Werkstoff weist einen symmetrisch zur Bauteilmitte außen erhöhten Anteil an Al auf, was einen sehr guten Oxidationsschutz für die Randzone bietet. Der innere Bereich dagegen ist nahezu nicht auflegiert, so dass hier auch die bisherigen mechanischen Eigenschaften des Substrats weitgehend nicht beeinflusst werden.

Anschließend wurden die so hergestellten Proben einem statischen Oxidationstest bei 900°C unterzogen, wobei die Änderung der Bauteilmasse zu definierten Zeiten mittels Verwiegen ermittelt wurde. In Figur 3 ist die Massenänderung bezogen auf die Bauteilfläche dargestellt. Es ist bei der unbeschichteten Probe eine starke Massenänderung zu beobachten, die auf starke Oxidation hinweist. Die gemäß der Erfindung beschichtete Probe zeigt eine sehr geringe Massezunahme, die auf eine sehr gute Oxidationsstabilität hinweist.

### Beispiel 4:

Bei einem gesinterten Formkörper (Hohlkugeln), erhältlich beim Fraunhofer-Institut für Fertigungstechnik und Angewandte Materialforschung, Dresden, aus Fe wurde über Pack-Inchromieren und Pack-Alitieren der Legierungsgehalt so eingestellt, dass der Formkörper aus einer FeCrAl-Legierung bestand, mit einer Zusammensetzung von Fe 72 %, Cr 20 %, Al 8 %. Durch die Elementeinbringung über Packverfahren mit simultaner Wärmebehandlung entstand eine besonders dichte auflegierte Wand bei den Hohlkugeln. Dies bewirkt, dass diese Strukturen sehr gute Oxidationseigenschaften gegenüber direkt über FeCrAl-Pulver, die nur in bestimmten Legierungsabstufungen verfügbar sind, hergestellte Hohlkugelformkörperstrukturen aufweisen.

### Beispiel 5:

Bei einem gesinterten Formkörper (Hohlkugeln), erhältlich beim Fraunhofer-Institut für Fertigungstechnik und Angewandte Materialforschung, Dresden, aus FeCr17 wurde über Pack-Alitieren der Legierungsgehalt so eingestellt, dass der Formkörper aus einer FeCrAl-Legierung mit einer Zusammensetzung von Fe 77 %, Cr 15 %, Al 8 % bestand. Durch die Elementeinbringung über das Packverfahren mit simultaner Wärmebehandlung entsteht bei den Hohlkugeln eine besonders dichte auflegierte Wand. Dies bewirkt, dass diese Strukturen sehr gute Oxidationseigenschaften gegenüber direkt über FeCrAl-Pulver hergestellte Hohlkugelformkörperstrukturen aufweisen. Außerdem lässt sich gegenüber den über FeCrAl-Pulver, die nur in bestimmten Legierungsabstufungen verfügbar sind, hergestellten Hohlkugelstrukturen der Al-Gehalt nach Wunsch frei einstellen.

### Beispiel 6:

Bei einem gesinterten Formkörper (Hohlkugeln), erhältlich beim Fraunhofer-Institut für Fertigungstechnik und Angewandte Materialforschung, Dresden, aus FeCr17 wurde über eine MOCVD-Aluminiumbeschichtung zunächst Rein-Aluminium aufgebracht und anschließend wurde in der Wärmebehandlung der Legierungsgehalt so eingestellt, dass der Formkörper aus einer FeCrAl-Legierung mit einer Zusammensetzung von Fe 77 %, Cr 15 %, Al 8 % bestand. Durch die Elementeinbringung über das Packverfahren mit simultaner Wärmebehandlung entstand bei den Hohlkugeln eine besonders dichte auflegierte Wand. Dies bewirkt, dass diese Strukturen sehr gute Oxidationseigenschaften gegenüber direkt über FeCrAl-Pulver hergestellte Hohlkugelformkörperstrukturen aufweisen. Außerdem lässt sich gegenüber den über FeCrAl-Pulver, die nur in bestimmten Legierungsabstufungen verfügbar sind, hergestellten Hohlkugelstrukturen der Al-Gehalt nach Wunsch frei einstellen.

### Beispiel 7:

Es wurden gesinterte FeCr17 Hohlkugeln, erhältlich beim Fraunhofer-Institut für Fertigungstechnik und Angewandte Materialforschung, Dresden, durch Klebstoff (Zellulosekleister) temporär in der Endform als nahezu dichtestes Kugelpaket untereinander und mit der Trägerplatte, der sogenannten Backplate, fixiert. Beim anschließenden über Pack-Alitieren wurde zum einen der Legierungsgehalt so eingestellt, dass der Formkörper aus einer FeCrAl-Legierung mit einer Zusammensetzung von Fe 77 %, Cr 15 %, Al 8 % bestand, zum anderen wurde aber auch simultan die Sinterung zum Gesamtkörper aus Hohlkugelpackung auf Backplate durchgeführt. Durch die Elementeinbringung über das Packverfahren mit gleichzeitiger Wärmebehandlung entstand bei den Hohlkugeln eine besonders dichte auflegierte Wand. Dies bewirkt, dass diese Strukturen sehr gute Oxidationseigenschaften gegenüber direkt über FeCrAl-Pulver hergestellte Hohlkugelformkörperstrukturen aufweisen. Außerdem lässt sich gegenüber den über FeCrAl-Pulver, die nur in bestimmten Legierungsabstufungen verfügbar sind, hergestellten Hohlkugelstrukturen der Al-Gehalt nach Wunsch frei einstellen.

## Patentansprüche

1. Verfahren zur Herstellung eines hochtemperaturbeständigen Werkstoffs aus einem Fe- oder FeCr- oder FeNi- oder FeNiCr-Substrat, umfassend die Schritte
a) Beschichtung des Substrats mit Al oder mit Cr und Al und
b) Diffusionswärmebehandlung des in Schritt a) beschichteten Substrats.

2. Verfahren nach Anspruch 1, **dadurch gekennzeichnet, dass** die Beschichtung a) über ein CVD-, Pack- oder Out-of-Pack-Verfahren erfolgt und dass die Diffusionswärmebehandlung b) simultan zur Beschichtung a) erfolgt.

3. Verfahren nach Anspruch 1, **dadurch gekennzeichnet, dass** die Beschichtung a) über Beschichtungsverfahren, ausgewählt aus der Gruppe, bestehend aus galvanischen Beschichtungsverfahren, Beschichtungen mittels ionischer Flüssigkeiten, Beschichtungen mittels MOCVD-Verfahren und Spritzverfahren und dass die Diffusionswärmebehandlung b) großteils getrennt von der Beschichtung a) erfolgt.

4. Verfahren nach irgendeinem der Ansprüche 1 bis 3, **dadurch gekennzeichnet, dass** die Diffusionswärmebehandlung bei einer Temperatur von 250°C bis 1600°C, vorzugsweise bei einer Temperatur von 800°C bis 1300°C, besonders bevorzugt bei einer Temperatur von 900°C bis 1200°C durchgeführt wird.

5. Verfahren nach irgendeinem der Ansprüche 1 bis 4, **dadurch gekennzeichnet, dass** die Diffusionswärmebehandlung für einen Zeitraum von 0,1 h bis 250 h, vorzugsweise von 2 h bis 16 h, besonders bevorzugt von 3 h bis 12 h erfolgt.

6. Verfahren nach irgendeinem der Ansprüche 1 bis 5, **dadurch gekennzeichnet, dass** die Diffusionswärmebehandlung im offenen Ofen, im Vakuum oder bei Unterdruck, vorzugsweise einem Druck von 10⁻⁸ bar oder größer, besonders bevorzugt von 1 mbar oder größer, und/oder in Gegenwart von Prozessgasen erfolgt.

7. Verfahren nach Anspruch 6, **dadurch gekennzeichnet, dass** die Prozessgase ausgewählt sind aus der Gruppe, bestehend aus Argon, Wasserstoff, Stickstoff, stickstoffhaltigen Gasen, kohlenstoffhaltigen Gasen, borhaltigen Gasen und deren Gemischen.

8. Verfahren nach Anspruch 7, **dadurch gekennzeichnet, dass** das kohlenstoffhaltige Gas ausgewählt ist aus der Gruppe, bestehend aus Methan, Ethan, Propan, Butan, Acetylen, Kohlenmonoxid und deren Gemischen.

9. Verfahren nach irgendeinem der Ansprüche 1 bis 8, **dadurch gekennzeichnet, dass** der Werkstoff zusätzlich Carbide und/oder Nitride und/oder Carbonitride und/oder Boride enthält.

10. Verfahren nach irgendeinem der Ansprüche 1 bis 9, **dadurch gekennzeichnet, dass** es als weiteren Schritt eine beschleunigte Abkühlung in Gegenwart von Prozessgasen und/oder anderen Medien umfasst.

11. Verfahren nach irgendeinem der Ansprüche 1 bis 10, **dadurch gekennzeichnet, dass** das Substrat ein kompaktes Substrat ist, vorzugsweise ausgewählt aus Bandmaterial oder kompakten Bauteilen.

12. Verfahren nach Anspruch 11, **dadurch gekennzeichnet, dass** es sich bei dem kompakten Substrat um ein dünnes Substrat handelt, wobei dessen geringste Wandstärke vorzugsweise maximal 5 mm oder weniger, bevorzugter 2 mm oder weniger, besonders bevorzugt 0,5 mm oder weniger beträgt.

13. Verfahren nach einem der Ansprüche 11 oder 12, **dadurch gekennzeichnet, dass** das Substrat aus un-, niedrig- oder hochlegiertem Cr-Stahl, NiCr-Stahl, Cr-Gusseisen, Cr-Stahlguss, NiCr-Stahlguss besteht und gegebenenfalls zusätzlich ein Element oder mehrere Elemente, ausgewählt aus W, Mo, Ni, Ta, Nb, Zr, V, Hf, Ru, Rh, Os, Ir, Pd, Pt, Re, Y, enthält.

14. Verfahren nach irgendeinem der Ansprüche 1 bis 13, **dadurch gekennzeichnet, dass** die Beschichtung und nachfolgende Diffusionswärmebehandlung des Substrats als Stückgut über Trommel- oder Gestellprozesse erfolgt.

15. Verfahren nach irgendeinem der Ansprüche 1 bis 13, **dadurch gekennzeichnet, dass** das Substrat ein Bandmaterial ist und als solches beschichtet und nachfolgend diffusionswärmebehandelt wird.

16. Verfahren nach irgendeinem der Ansprüche 1 bis 15, **dadurch gekennzeichnet, dass** das im Schritt a) erhaltene beschichtete Substrat oder der durch die Schritte a) und b) erhaltene Werkstoff in einem weiteren Schritt durch Tiefzieh- oder anderen Umformprozessen vor und/oder nach der Diffusionswärmebehandlung in die gewünschte Endform gebracht wird.

17. Verfahren nach irgendeinem der Ansprüche 1 bis 10, **dadurch gekennzeichnet, dass** das Substrat ein poröser Formkörper ist, ausgewählt aus der Gruppe, bestehend aus metallischen gesinterten Hohlkugelstrukturen, aus metallischen Schwammstrukturen oder aus sonstigen metallischen porösen Strukturen.

18. Verfahren nach irgendeinem der Ansprüche 1 bis 10, **dadurch gekennzeichnet, dass** das Substrat aus Einzelkörper besteht, die temporär durch Klebstoffe in der Endform fixiert sind.

19. Verfahren nach Anspruch 18, **dadurch gekennzeichnet, dass** die Einzelkörper während der Diffusionswärmebehandlung b) zu einem porösen Formkörper gesintert werden.

20. Verfahren nach irgendeinem der Ansprüche 17 bis 19, **dadurch gekennzeichnet, dass** das Substrat aus einem un-, niedrig- oder hochlegierte Eisenbasiswerkstoff oder einem FeCr- oder FeNi- oder FeNiCr-Werkstoff besteht, wobei der Werkstoff zusätzlich die Elemente W, Mo, Ta, Nb, Zr, V, Hf, Ru, Rh, Os, Ir, Pd, Pt, Re, Y enthalten kann.

21. Verfahren nach irgendeinem der Ansprüche 17 bis 20, **dadurch gekennzeichnet, dass** der Werkstoff in der gewünschten Endform und/oder mit den gewünschten Endabmessungen hergestellt wird.

22. Werkstoff herstellbar gemäß einem Verfahren nach einem der Ansprüche 1 bis 21.

23. Werkstoff nach Anspruch 22, **dadurch gekennzeichnet, dass** der Werkstoff ein kompaktes Gefüge mit einem Hohlraumanteil unter 5 Vol.-% aufweist.

24. Werkstoff nach Anspruch 22, **dadurch gekennzeichnet, dass** der Werkstoff einen Hohlraumanteil von über 65 Vol.-% aufweist.

25. Werkstoff nach irgendeinem der Ansprüche 22 bis 24, **dadurch gekennzeichnet, dass** der Werkstoff einen Aluminiumgehalt von über 6 Gew.-% aufweist.

26. Werkstoff nach irgendeinem der Ansprüche 22 bis 25, **dadurch gekennzeichnet, dass** der Werkstoff Carbide und/oder Nitride und/oder Carbonitride und/oder Boride enthält.

27. Werkstoff nach irgendeinem der Ansprüche 22 bis 26, **dadurch gekennzeichnet, dass** der Werkstoff eine Vickershärte in einem Bereich von 120 bis 1150, gemessen nach DIN EN ISO 6507-1 (2004-07), aufweist.

28. Erzeugnis, umfassend einen Werkstoff nach einem der Ansprüche 22 bis 27.

29. Verwendung des Erzeugnisses gemäß Anspruch 28 in der Luftfahrt, im Abgasbereich von Automotivanwendung, in der Petrochemie und allgemeinen Industrie, insbesondere wenn Oxidationsschutz, Zunderschutz, Heißgas-Korrosionsschutz, zum Schutz gegen Metalldusting, zum Schutz vor Sulfidierung, als Korrosionsschutz, als Verschleißschutz, zur Erhöhung des abrasiven Widerstandes, zur Reduzierung der Adhäsion, der Verbesserung der tribologischen Eigenschaften und/oder zum Schutz vor aggressiven Metallschmelzen benötigt wird.

30. Verwendung des Erzeugnisses gemäß Anspruch 28 als Leichtbauformkörper, insbesondere als oxidationsbeständige Anstreifdichtung in der Luftfahrt sowie als Werkstück und Bauteil im allgemeinen Maschinenbau, der Bau- und Fahrzeugbauindustrie, der Luftfahrt, chemischen und petrochemischen Industrie sowie der allgemeinen Industrie, insbesondere wenn Oxidationsschutz, Zunderschutz, Heißgas-Korrosionsschutz, Schutz gegen Metalldusting, Schutz vor Sulfidierung, Korrosionsschutz, Verschleißschutz, eine Erhöhung des abrasiven Widerstandes, Reduzierung der Adhäsion und/oder Verbesserung der tribologischen Eigenschaften benötigt wird.
